Europäisches Patentamt

European Patent Office

Office européen des brevets

(11) Publication number: **0 518 545 A1**

# EUROPEAN PATENT APPLICATION

(21) Application number: **92305052.0**

(51) Int. Cl.5: **G03F 7/40**

(22) Date of filing: **02.06.92**

(30) Priority: **11.06.91 US 713479**

(43) Date of publication of application:
**16.12.92 Bulletin 92/51**

(84) Designated Contracting States:
**DE FR GB IT**

(71) Applicant: **AMERICAN TELEPHONE AND TELEGRAPH COMPANY**
**550 Madison Avenue**
**New York, NY 10022(US)**

(72) Inventor: **Jurgensen, Charles Willard**
**27 Choctaw Ridge Road**
**Branchburg, New Jersey 08876(US)**
Inventor: **Novembre, Anthony Edward**
**645 Summit Road**
**Union, New Jersey 07083(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) **Dry lithographic etching with gaseous mixtures of oxygen and chlorine.**

(57) Patterning of a layer of material (11) that can be etched with a gaseous mixture of oxygen and chlorine as etchant species, such as a chromium or a chromium-containing compound layer layer, is accomplished by using a patterned organometallic resist layer (12), such as a polymer which contains silicon or germanium. During anisotropic Reactive Ion Etching (RIE) of the layer of material with a gaseous mixture of oxygen and chlorine, the ratio of the etching rate of the layer of material to the etching rate of the resist layer increased--i.e., the etching selectivity is improved--by means of an earlier bombardment of the organometallic resist with oxygen ions after the patterning of the organometallic resist layer, but prior to the RIE of the layer of material.

FIG. 1

EP 0 518 545 A1

## Background of the Invention

Lithographic etching of layers of material for subsequent use as either photolithographic or X-ray masks, is important, for example, in conjunction with fabricating semiconductor integrated circuits or other devices--using such masks for pattern transfer from the mask to the device by either optical or X-ray lithography, respectively. Commercially promising layers of material for such masks include layers composed of chrome (chromium), chromium-containing compounds, and tungsten. When such masks are used in optical lithography systems where the lateral magnification differs from unity--typically a 5:1 linear reduction--they are typically also called "reticles".

In U.S. Patent No. 4,876,164 issued on October 24, 1989, to Watakabe et al, a method is described for patterning a chrome layer so that it could be used as a mask. In that method a chrome layer is deposited on a transparent glass substrate. An organic resist layer is then formed on the chrome layer, and the resist layer is patterned, as by optical or electron beam scanning (direct writing) followed by wet developing. Then the thus exposed portions of the chrome layer are etched away by means of a gas plasma process using a gaseous mixture that contains oxygen and chlorine. Finally the patterned resist layer is removed.

A problem with the foregoing process, as was found by Watakabe et al, is a low selectivity of the plasma etching of the chrome relative to the etching of the resist. That is, the ratio of the etch rate of the chrome to that of the resist is undesirably low, typically (as we have found) only about 1.5/1.0 or less when reactive ion etching (RIE) is used, whereby the required thickness of the resist layer is undesirably high; so that during the etching of the chrome, the lateral width of the resist layer is undesirably reduced, whereby the resolution limit (sharpness) of the pattern etched into the chrome layer is degraded.

In a paper authored by S. Tedesco et al entitled "Dry Etching for High Resolution Maskmaking," published in SPIE, Vol. 1264, Optical/Laser Microlithography III (1990), pp. 144-157, a method for etching a chrome layer is disclosed in which the chrome layer is first overlaid with a uniformly thick layer of an organic resist. Predetermined portions of this resist layer are then silylated--i.e., imbued with silicon to form an organosilicon resist--in accordance with a pattern of optical radiation to which the resist layer had been exposed. Thus some portions of the resist are silylated, and others are not. Then the entire resist layer is subjected to an oxygen ion bombardment to remove those portions of the resist layer which were not silylated, whereby portions of the chrome layer become exposed.

Finally, the exposed portions of the chrome layer are removed by anisotropic dry reactive ion etching with a mixture of oxygen and chlorine, whereby the pattern of the optical radiation is transferred to the chrome layer, in order to form a patterned chrome layer.

A major problem with this method of S. Tedesco et al is that it is difficult to control the lateral contours of the silylated portions of the resist layer. Hence it is difficult to control the lateral uniformity of the contours of the portions of the resist layer that are removed during the oxygen ion bombardment. Also various defects in these contours are produced. Consequently, the contours of the patterned chrome layer that remain after the etching with oxygen and chlorine are also difficult to control and also contain defects, so that the contours of the patterned chrome layer do not represent a faithful representation of the pattern of the optical radiation.

Therefore, it would be desirable to have a method for fabricating masks composed of chrome (or of other material that can be anisotropically etched in a gaseous mixture that contains oxygen and chlorine as the etchant species) that does not suffer from the shortcomings of prior art.

## Summary of the Invention

In accordance with the invention, we provide a process as set forth in claim 1. It is further advantageous for the process to have, in addition, the feature recited in claim 2. It is yet further advantageous for the process to have the feature recited in claim 3. Alternatively, it is further advantageous for the process to have the feature recited in claim 4. It is yet further advantageous for the process to have the feature recited in claim 5. It is also advantageous for the process to have the features recited in claims 6 through 10.

## Brief Description of the Drawing(s)

FIGS. 1-3 are elevational views in cross section of various stages in the manufacture of a photolithographic mask 300, in accordance with a specific embodiment of the invention; and
FIGS. 4-5 are elevational view in cross section of various stages in the manufacture of an X-ray lithographic mask 500, in accordance with another specific embodiment of the invention.

Only for the sake of clarity, none of the drawings is to scale.

## Detailed Description

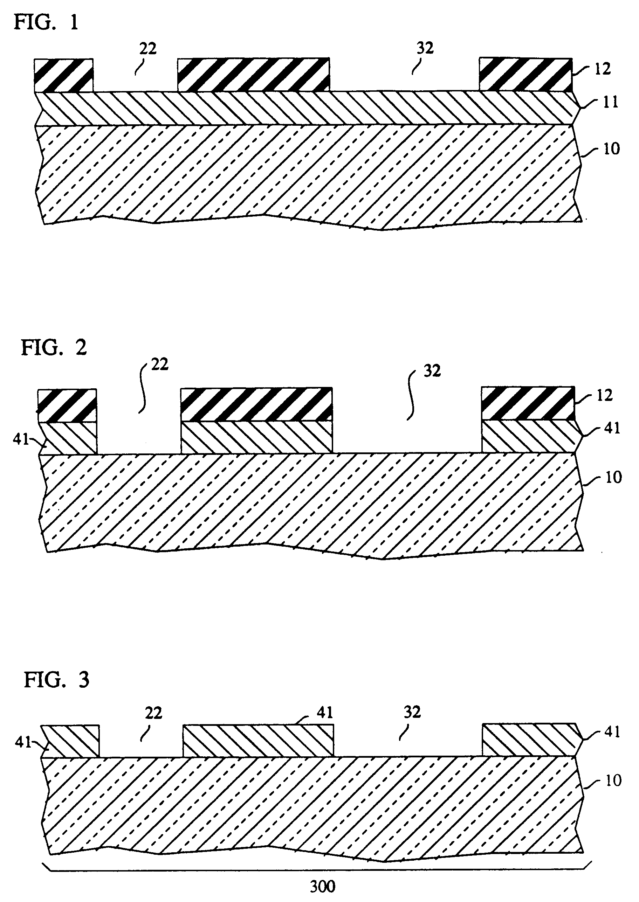

Referring now to FIG. 1, upon a major top surface of a transparent substrate 10, typically silica glass, there is located a layer of material 11 such as a metallic layer 11, typically of uniformly thick chrome. At any rate, this layer of material 11 has the property that it can be etched in a gaseous mixture of oxygen and chlorine as etchant species. This metallic layer 11 is typically deposited by means of evaporation or by sputtering from a metal target; and it has a uniform thickness of typically about 100 nm (1,000 Å). Upon the top surface of this metallic layer 11 is located a polymer resist layer 12 which contains silicon in the approximate range of 5 to 30 wt per centum, so that it is an organometallic resist layer, and more specifically is an organosilicon resist layer. The organometallic resist layer 12 is typically a silicon-containing polymer such as poly(trimethylsilylmethyl methacrylate-co-chloromethylstyrene), but other suitable silicon-containing polymer resists can be used. Advantageously, the silicon is uniformly distributed in three dimensions throughout the organometallic resist layer 12.

Originally (not shown) this resist layer 12 (everywhere) had a uniform thickness, typically in the range of about 0.30 to 1.5 $\mu$m. To pattern the resist layer 12, it was subjected to an electron beam, typically of the scanning (direct-writing) type, in accordance with the pattern ultimately desired in the metallic layer 11 (in case the resist layer 12 is composed of a positive tone resist) or in accordance with the complement of the pattern ultimately desired in the metallic layer 11 (in case the resist layer 12 is a negative tone resist). After a (typically wet) development, the resist layer 12 still has a uniform thickness except for spaces 22,32 penetrating down to the top surface of the metallic layer 11.

The patterned organometallic resist is subjected to an ion bombardment step with oxygen (absent chlorine), whereby the etch ratio of chrome/resist during the RIE step with oxygen and chlorine is improved. During this bombardment, the oxygen ions are accelerated to a kinetic energy of typically about 300 eV at a gas pressure of typically about 1.0 Pascal and a power density of typically about 0.5 Watt/cm$^2$.

The metallic layer 11 is then etched at its exposed portions to form a patterned metallic layer 41 (FIG. 2). More specifically, for example, the top surface of the device being manufactured is subjected to an anisotropic RIE step, using an etchant gas mixture containing oxygen and chlorine, typically in a volume ratio in the approximate range of between 0.25/1.0 and 4.0/1.0, preferably approximately 1.0/1.0. During this step the oxygen and chlorine ions are accelerated to a kinetic energy of typically about 100 eV at a gas pressure of typically about 10 Pascal and a power density of typically about 0.5 Watt/cm$^2$. In this way, the spaces 22,32 penetrate through the chrome layer 11, where a patterned chrome layer 41 (FIG. 2) is formed. Other gases, such as nitrogen or noble gases, may be added to the etchant gas mixture for the purpose of increasing the ion flux or stabilizing the plasma, or for both purposes.

After the etching of the chrome layer 11 (FIG. 1) to form the patterned chrome layer 41 (FIG. 2), the patterned resist layer 12 is removed, such as by means of an oxygen plasma containing a few per centum of fluorine or of a fluorine-containing compound, as known in the art. In this way the desired photolithographic mask or reticle 300 (FIG. 3) is formed.

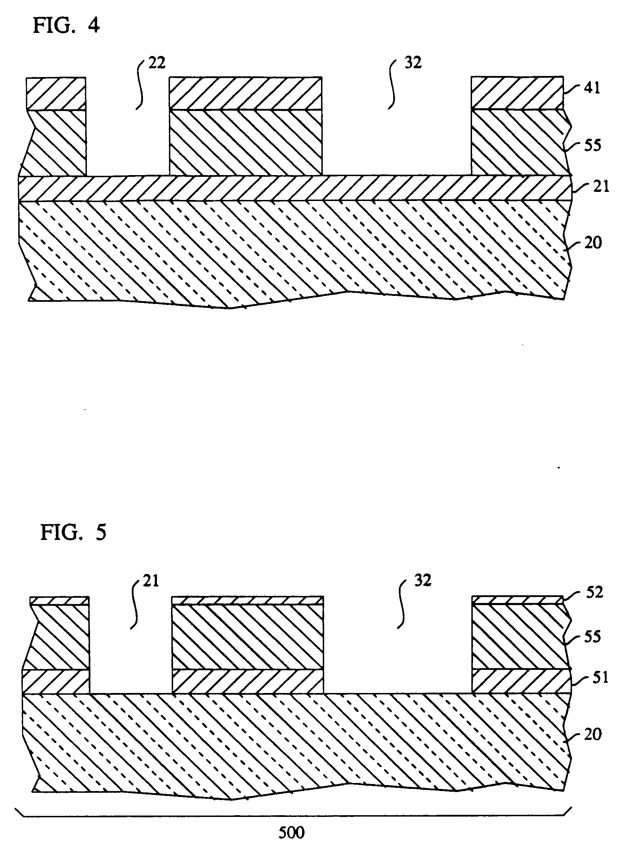

Turning to FIG. 5, in accordance with another specific embodiment of the invention, an X-ray lithographic mask 500 is composed of a supporting membrane 20, an optional patterned chrome layer 51, a patterned tungsten layer 55, and a patterned chrome layer 52. FIG. 4 shows an earlier stage in its manufacture. The chrome layer 41 has been patterned in the same manner as described above, except that it now is located upon the top surface of a uniformly thick tungsten layer 55 which, in turn, has been patterned by means of RIE using a gas mixture of sulphur hexafluoride and carbon monobromotrifluoride, as known in the art, the patterned chrome layer 41 being used as a protective mask. The (optional) chromium layer 21 located beneath the tungsten layer 55 serves as an etch stop, for terminating the etching of tungsten, as well as a glue for promoting adherence of the tungsten layer 55 to the membrane 20. Then the chrome layer 51 is etched by means of RIE again with a gas mixture chlorine and oxygen, but without an auxiliary bombardment with oxygen. In this way, the chrome layer 21 is patterned to form the patterned chrome layer 51, and at the same time the thickness of the patterned chrome layer 41 is reduced, to form a patterned chrome layer 52 of reduced thickness or even zero thickness depending upon the ratio of the thicknesses of the chrome layers 21 and 41. Thus the desired X-ray mask 500 is formed.

In an illustrative example, the thickness of the chrome layer 41 is about 30 nm; of the tungsten layer 55, about 500 nm; and of the chrome layer 21, about 20 nm. The membrane is typically essentially silicon, silicon nitride, silicon carbide, or boron nitride, as known in the art.

Instead of chrome, a chromium-containing material--such as chromium compound containing oxygen or nitrogen or both (e.g., chromium oxynitride), which also can be etched with a gaseous mixture of oxygen and chlorine by a glow discharge pattern-transfer process--can be used for any of the metallic layers 11 and 21.

The (uniform) concentration of germanium in the aforementioned resist advantageously is the approximate range of 10 to 33 wt per centum, typically about 28 to 30 wt per centum.

Although the invention has been described in terms of specific embodiments, various modifications can be made without departing from the scope of the invention. For example, the RIE etching of the metallic layer 51 can be omitted in case optical alignment of the mask is not required. Instead of adding silicon or germanium to the organic resist, other metals that form refractory oxides can be added to form an organometallic resist. Finally, the tungsten layer 55 (FIG. 5) can be a patterned metallization or other layer in an integrated circuit or other device, with the membrane 20 replaced by an insulating layer or other component of the integrated circuit or other device that is being fabricated.

## Claims

1. A method of lithographic etching a first layer of material (11) that can be etched by a gaseous mixture that contains oxygen and chlorine comprising the steps of:
   (a) forming the first layer of material;
   (b) forming an organometallic resist layer having a substantially uniform composition on a surface of the layer of material;
   (c) patterning the organometallic resist layer, whereby a patterned organometallic resist layer (12) is formed, and whereby portions of the surface of the layer of material become exposed portions thereof; and
   (d) subjecting the exposed portions of the surface of the first layer of material to an anisotropic etching procedure with a gas mixture comprising oxygen and chlorine, whereby the exposed portions of the first layer of material are etched and a patterned layer (41) of the first material is formed;
   CHARACTERIZED BY THE STEP OF bombarding the patterned organometallic resist layer with oxygen ions between steps (c) and (d).

2. The method of claim 1 in which the resist layer contains silicon in a concentration that is sufficient to increase the ratio of the etching rate of the first layer of material to the etching rate of the resist layer during the anisotropic etching procedure.

3. The method of claim 2 in which the first layer of material is essentially chrome or a compound that contains chromium.

4. The method of claim 1 in which the resist layer contains germanium in a concentration that is sufficient to increase the ratio of the etching rate of the first layer of material to the etching rate of the resist layer during the anisotropic etching procedure.

5. The method of claim 4 in which the first layer of material is essentially chrome or a compound that contains chromium.

6. A method of manufacturing a mask in accordance with claim 1 further comprising the steps of:
   forming prior to step (a) a second layer of material on which the first layer of material is to be formed, the second layer being opaque to the X-ray radiation to be used in the X-ray lithography, and the second layer being located upon a supporting membrane which is transparent to the X-ray radiation to be used; and subjecting subsequent to step (d) the thereby exposed portions of the second layer to anisotropic etching, whereby the pattern of the patterned organometallic resist layer is transferred to the second layer, so that the second layer becomes a patterned second layer which can be used as an X-ray lithographic mask.

7. The method of claim 6 in which the resist layer contains silicon in a concentration that is sufficient to increase the ratio of the etching rate of the first layer of material to the etching rate of the resist layer during the anisotropic etching procedure.

8. The method of claim 7 the layer of material is essentially chrome or a compound that contains chromium.

9. The method of claim 6 in which the resist layer contains germanium in a concentration that is sufficient to increase the ratio of the etching rate of the first layer of material to the etching rate of the resist layer during the anisotropic etching procedure.

10. The method of claim 9 in which layer of material is essentially chrome or a compound that contains chromium.

FIG. 1

FIG. 2

FIG. 3

300

FIG. 4

FIG. 5

500

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | WORLD PATENTS INDEX LATEST Week 8930, Derwent Publications Ltd., London, GB; AN 89-216614 & JP-A-1 154 050 (TOSHIBA K.K.) 16 June 1989 * abstract * ----- | 1 | G03F7/40 |
|   |   |   | **TECHNICAL FIELDS SEARCHED (Int. Cl.5)** |
|   |   |   | G03F |

The present search report has been drawn up for all claims

| Place of search | Date of completion of the search | Examiner |
|---|---|---|
| THE HAGUE | 27 AUGUST 1992 | DUPART J-M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)